# EUROPEAN PATENT APPLICATION

(11) **EP 4 683 452 A1**
(43) Date of publication of application: **21.01.2026**
(21) Application number: 25189584.3
(22) Date of filing: 15.07.2025
(51) Int. Cl.: H10B 12/00, G11C 5/06, G11C 8/14, G11C 8/08

(54) **SEMICONDUCTOR MEMORY DEVICE**

(30) Priority: 16.07.2024 KR 20240094011
(71) Applicant: Samsung Electronics Co., Ltd., Suwon-si, Gyeonggi-do 16677 (KR)
(72) Inventor: SEO, Duckyoung, 16677 Suwon-si (KR); KANG, Kyuchang, 16677 Suwon-si (KR)
(74) Representative: Marks & Clerk LLP

(57) **Abstract**

A semiconductor memory device is provided. The device includes: first word lines in N layers, the first word lines extending from a first stack region toward first stair regions; second word lines in the N layers, the second word lines extending from a second stack region toward second stair regions; first memory cells provided in the first stack region; second memory cells provided in the second stack region; N first word line contacts connected to the first word lines in the first stair regions; and N second word line contacts connected to the second word lines in the second stair regions. A first word line in a Kth layer (K being an integer from 1 to N) among the first word lines and a second word line in an (N-K+1)th layer among the second word lines are commonly connected to one sub-word line driver.

## Description

### BACKGROUND

The present disclosure relates to relates to a semiconductor memory device, and more particularly to, a vertical semiconductor memory device having a three-dimensional structure.

There is a need to increase the integration level of memory devices to meet performance and storage requirements. The integration level of two-dimensional memory devices is primarily determined by the area occupied by a unit memory cell and is thus heavily influenced by the level of fine patterning technology. However, fine patterning requires complex manufacturing equipment, and the areas of chip dies are limited. Thus, there is a limit to the integration level of two-dimensional memory devices.

### SUMMARY

Example embodiments provide a three-dimensional vertical semiconductor memory device having stable performance and enhanced reliability.

However, aspects of the present disclosure are not limited thereto, and other aspects will be understood by those skilled in the art through the following description.

According to an aspect of an example embodiment, a semiconductor memory device includes: a substrate including a first stack region, first stair regions provided at ends of the first stack region, a second stack region, and second stair regions provided at ends of the second stack region; first word lines in N layers (where N refers to an integer greater than or equal to 2), the first word lines extending from the first stack region toward the first stair regions and being spaced apart from each other in a vertical direction; second word lines in the N layers, the second word lines extending from the second stack region toward the second stair regions and being spaced apart from each other in the vertical direction; first bit lines in the first stack region extending in the vertical direction; second bit lines in the second stack region extending in the vertical direction; first memory cells provided in the first stack region and between the first word lines and the first bit lines; second memory cells provided in the second stack region and between the second word lines and the second bit lines; N first word line contacts connected to pads of the first word lines in the first stair regions; and N second word line contacts connected to pads of the second word lines in the second stair regions. A first word line in a Kth layer (wherein, K refers to an integer from 1 to N) among the first word lines in the N layers and a second word line in an (N-K+1)th layer among the second word lines in the N layers are commonly connected to one sub-word line driver.

According to another aspect of an example embodiment, a semiconductor memory device includes: a lower structure; and an upper structure on the lower structure. The lower structure includes: a cell substrate including a first stack region, first stair regions provided at ends of the first stack region, a second stack region, and second stair regions provided at ends of the second stack region; first word lines in N layers (where N refers to an integer greater than or equal to 2), the first word lines extending from the first stack region toward the first stair regions and being spaced apart from each other in a vertical direction; second word lines in the N layers, the second word lines extending from the second stack region toward the second stair regions and being spaced apart from each other in the vertical direction; first bit lines in the first stack region extending in the vertical direction; second bit lines in the second stack region extending in the vertical direction; first memory cells provided in the first stack region between the first word lines and the first bit lines; second memory cells provided in the second stack region between the second word lines and the second bit lines; N first word line contacts connected to the first word lines of the N layers in the first stair regions; and N second word line contacts connected to the second word lines of the N layers in the second stair regions. The upper structure includes: a core/periphery substrate; a plurality of sub-word line drivers; and a plurality of interconnect lines connecting the plurality of sub-word line drivers to the N first word line contacts and the N second word line contacts. A first word line in a Kth layer (wherein, K refers to an integer from 1 to N) among the first word lines in the N layers and a second word line in an (N-K+1)th layer among the second word lines in the N layers are commonly connected to one of the plurality of sub-word line drivers in the upper structure.

According to another aspect of an example embodiment, a semiconductor memory device includes: a substrate including a first stack region, first stair regions provided at both ends of the first stack region, a second stack region, and second stair regions provided at both ends of the second stack region; first word lines in N layers (where N refers to an integer greater than or equal to 2), the first word lines extending from the first stack region toward the first stair regions and being spaced apart from each other in a vertical direction; second word lines in the N layers, the second word lines extending from the second stack region toward the second stair regions and being spaced apart from each other in the vertical direction; a plurality of sub-word line drivers connected to the first word lines in the N layers and the second word lines in the N layers; N first word line contacts connected to pads of the first word lines of the N layers in the first stair regions; and N second word line contacts connected to pads of the second word lines of the N layers in the second stair regions. A first word line in a Kth layer (wherein, K refers to an integer from 1 to N) among the first word lines in the N layers and a second word line in an (N-K+1)th layer among the second word lines in the N layers are commonly connected to one of the plurality of sub-word line drivers.

At least some of the above and other features of the invention are set out in the claims.

### BRIEF DESCRIPTION OF DRAWINGS

The above and other aspects and features will be more clearly understood from the following description of example embodiments, taken in conjunction with the accompanying drawings, in which:
FIG. 1 is an equivalent circuit diagram illustrating a stacked-type cell array of a semiconductor memory device according to an example embodiment;
FIG. 2 is a perspective diagram illustrating a semiconductor memory device according to an example embodiment;
FIGS. 3 and 4 are a cross-sectional diagram and a plan diagram schematically illustrating a region AA of FIG. 2;
FIGS. 5 to 7 are diagrams illustrating components of a semiconductor memory device according to an example embodiment;
FIG. 8 is a plan layout schematically illustrating a semiconductor memory device according to an example embodiment;
FIGS. 9 and 10 are plan diagrams respectively illustrating a lower structure and an upper structure of a semiconductor memory device according to an example embodiment; and
FIG. 11 is a block diagram illustrating a semiconductor memory device according to an example embodiment.

### DETAILED DESCRIPTION

Hereinafter, example embodiments will be described with reference to the accompanying drawings. Like components are denoted by like reference numerals throughout the specification, and repeated descriptions thereof are omitted. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

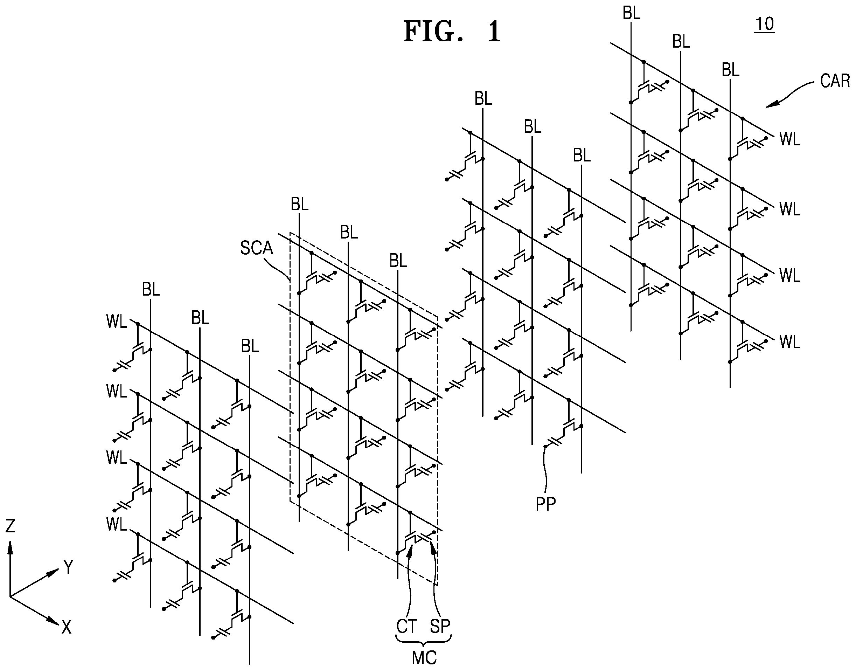

FIG. 1 is an equivalent circuit diagram illustrating a stacked-type cell array of a semiconductor memory device 10 according to an example embodiment.

Referring to FIG. 1, a cell array structure CAR of the semiconductor memory device 10 may include a plurality of sub-cell arrays SCA.

The sub-cell arrays SCA may each include a plurality of bit lines BL, a plurality of word lines WL, and a plurality of memory cells MC. Each of the memory cells MC may include a cell transistor CT and a data storage element (i.e., data storage circuit element) SP.

The cell transistor CT may be disposed between one word line WL and one bit line BL. The data storage element SP may be connected to the cell transistor CT. The data storage element SP may be a memory element capable of storing data.

The data storage element SP may be a memory element using a capacitor, a memory element using a magnetic tunnel junction, or a memory element using a variable resistor including a phase-change material. In the semiconductor memory device 10, the memory cell MC may be a dynamic random access memory (DRAM) cell, and the data storage element SP may be a capacitor. Nevertheless, the semiconductor memory device 10 is not limited to a DRAM device and may be any form of memory device. In particular embodiments, the semiconductor memory device 10 is a random access memory (RAM) device, such as a dynamic RAM (DRAM) device, a magnetoresistive RAM (MRAM) device, a resistive RAM (reRAM) device, or a phase change memory (PCM). Having said this, embodiments are not limited to RAM, and alternative forms of semiconductor memory device are possible, such as flash memory. That is, while particular embodiments include capacitors as the data storage elements SP, alternative forms of data storage element are possible. The semiconductor memory device 10 may be a volatile memory device or a non-volatile memory device.

The word lines WL may be conductive patterns (for example, metal lines) arranged above and spaced apart from a substrate. The word lines WL may extend in a first horizontal direction (X direction). In each of the sub-cell arrays SCA, the word lines WL may be spaced apart from each other in a vertical direction (Z direction). The first horizontal direction (X direction) may be parallel with an upper surface (e.g. a main surface) of the substrate. The vertical direction (Z direction) may be perpendicular to the upper surface of the substrate. As described herein, the term "vertical" may refer to a direction perpendicular to the upper surface of the substrate, and the term "horizontal" may refer to a direction parallel to the upper surface of the substrate. The vertical direction may define a height direction. Elements described as "above" other elements may be located further along the vertical direction than the other elements. It will be appreciated that these directions and positions are defined relative to the structure of the device, and therefore need not imply any particular orientation of the device in use.

The bit lines BL may be conductive patterns (for example, metal lines) extending from the substrate in the vertical direction (Z direction). In each of the sub-cell arrays SCA, the bit lines BL may be spaced apart from each other in the first horizontal direction (X direction).

In the cell array structure CAR, the word lines WL may extend in the first horizontal direction (X direction) and may be spaced apart from each other in a second horizontal direction (Y direction) and the vertical direction (Z direction). In addition, the bit lines BL may extend in the vertical direction (Z direction) and may be spaced apart from each other in the first horizontal direction (X direction) and the second horizontal direction (Y direction). The sub-cell arrays SCA may be arranged in the second horizontal direction (Y direction). The second horizontal direction (Y direction) may be parallel with the upper surface of the substrate. Here, the first horizontal direction (X direction) and the second horizontal direction (Y direction) may cross each other (e.g. may be perpendicular to each other).

A gate of the cell transistor CT may be connected to a word line WL, and a source region of the cell transistor CT may be connected to a bit line BL. In addition, a drain region of the cell transistor CT may be connected to the data storage element SP. In some example embodiments, the data storage element SP may be a capacitor including a first electrode, a second electrode, and a capacitor dielectric layer arranged between the first electrode and the second electrode. In this case, the first electrode of the capacitor may be connected to the drain region of the cell transistor CT, and the second electrode of the capacitor may be connected to ground wiring PP.

In some example embodiments, the source region and the drain region of the cell transistor CT, and the data storage element SP may be arranged in the second horizontal direction (Y direction) from the bit line BL connected to the source region of the cell transistor CT. Source regions of cell transistors CT respectively connected to two adjacent bit lines BL in the second horizontal direction (Y direction), drain regions of the cell transistors CT, and corresponding data storage elements SP may be arranged in opposite directions.

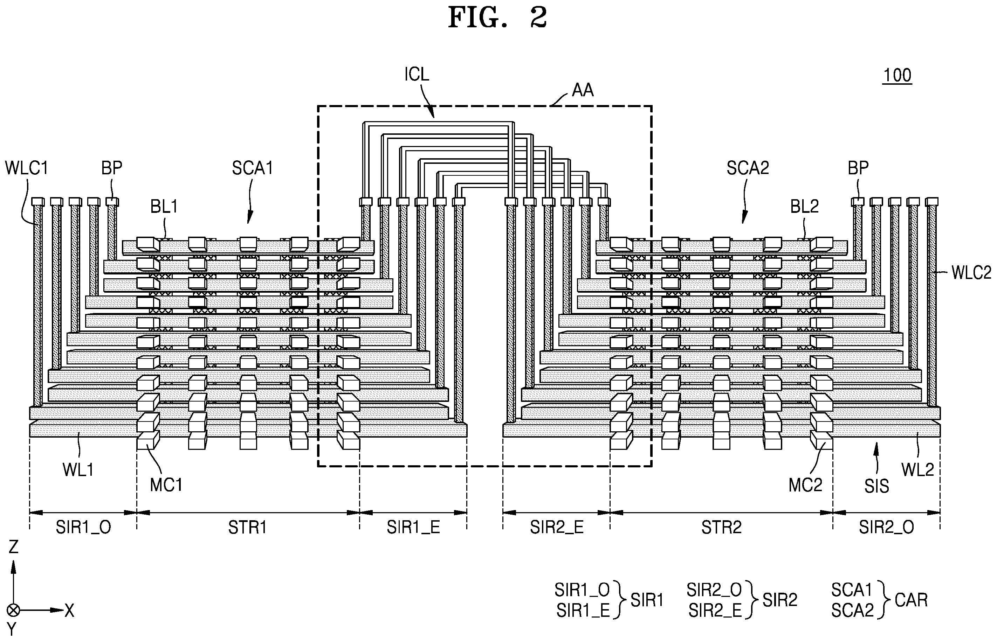

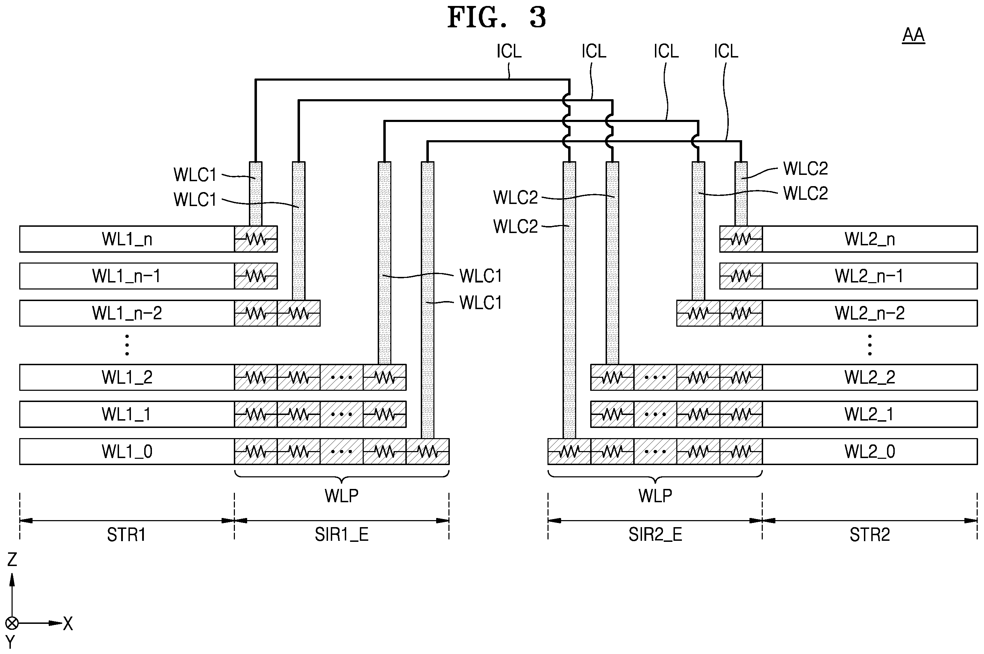

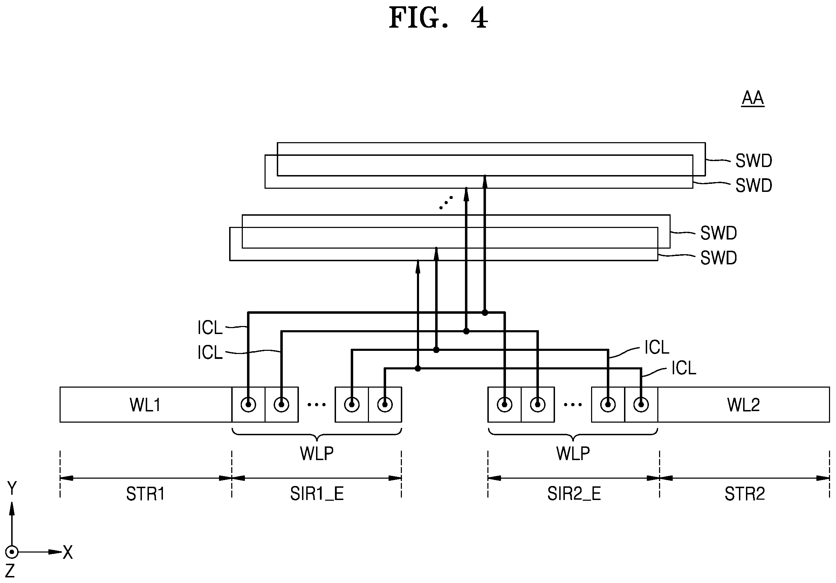

FIG. 2 is a perspective diagram illustrating a semiconductor memory device 100 according to an example embodiment. FIGS. 3 and 4 are a cross-sectional diagram and a plan diagram schematically illustrating a region AA of FIG. 2.

Referring to FIGS. 2 to 4 together, the semiconductor memory device 100 may include a first stack region STR1 and a second stack region STR2 that are adjacent to each other, and stair regions that are provided on both sides of each of the first and second stack regions STR1 and STR2, for example first stair regions SIR1 on both sides of the first stack region STR1 and second stair region SIR2 on both sides of the second stack regions STR2.

Cell array structures CAR may be provided in the first and second stack regions STR1 and STR2, and stair structures SIS may be provided in the first and second stair regions SIR1 and SIR2. A pair of first stair regions SIR1 may be provided on both sides of the first stack region STR1 in a first horizontal direction (X direction). In addition, a pair of second stair regions SIR2 may be provided on both sides of the second stack region STR2 in the first horizontal direction (X direction).

In some example embodiments, first and second stair regions SIR1 and SIR2 disposed on sides of the first and second stack regions STR1 and STR2 in the first horizontal direction (X direction) may be referred to as first and second odd stair regions SIR1_O and SIR2_O, and first and second stair regions SIR1 and SIR2 disposed on the other sides of the first and second stack regions STR1 and STR2 in the first horizontal direction (X direction) may be referred to as first and second even stair regions SIR1_E and SIR2_E.

That is, the stair structures SIS may be respectively provided in the first and second odd stair regions SIR1_O and SIR2_O and the first and second even stair regions SIR1_E and SIR2_E. In some example embodiments, the first even stair region SIR1_E and the second even stair region SIR2_E may face each other. Alternatively, the first odd stair region SIR1_O and the second odd stair region SIR2_O may face each other.

The cell array structures CAR may include, for example, first and second sub-cell arrays SCA1 and SCA2 that are adjacent to each other. In some example embodiments, the first and second sub-cell arrays SCA1 and SCA2 may be arranged in the first horizontal direction (X direction).

The first sub-cell array SCA1 may include a plurality of first word lines WL1, a plurality of first bit lines BL1, and a plurality of first memory cells MC1. Each of the first memory cells MC1 may include a cell transistor CT and a data storage element SP. In addition, the second sub-cell array SCA2 may include a plurality of second word lines WL2, a plurality of second bit lines BL2, and a plurality of second memory cells MC2. Each of the second memory cells MC2 may include a cell transistor CT and a data storage element SP.

The first and second word lines WL1 and WL2 may extend in the first horizontal direction (X direction). In the cell array structures CAR, the first and second word lines WL1 and WL2 may extend in the first horizontal direction (X direction) and may be spaced apart from each other in a second horizontal direction (Y direction) and a vertical direction (Z direction).

The first and second bit lines BL1 and BL2 may extend from a substrate in the vertical direction (Z direction). In the cell array structures CAR, the first and second bit lines BL1 and BL2 may extend in the vertical direction (Z direction), and may be spaced apart from each other in the first horizontal direction (X direction) and the second horizontal direction (Y direction).

One cell transistor CT may be disposed between each of first word lines WL1 and each of the first bit lines BL1. Data storage elements SP may be respectively connected to the cell transistors CT. The data storage elements SP may each be a memory element capable of storing data. Gates of the cell transistors CT may be connected to the first and second word lines WL1 and WL2, and source regions of the cell transistors CT may be connected to the first and second bit lines BL1 and BL2. The data storage elements SP may be respectively connected to drain regions of the cell transistors CT.

In some example embodiments, the source regions and the drain regions of the cell transistors CT, and the data storage elements SP may be arranged in the second horizontal direction (Y direction) from the first and second bit lines BL1 and BL2 connected to the source regions of the cell transistors CT. Source regions of cell transistors CT respectively connected to two adjacent first bit lines BL1 in the second horizontal direction (Y direction), drain regions of the cell transistors CT, and corresponding data storage elements SP may be arranged in opposite directions. In addition, source regions of cell transistors CT respectively connected to two adjacent second bit lines BL2 in the second horizontal direction (Y direction), drain regions of the cell transistors CT, and corresponding data storage elements SP may be arranged in opposite directions.

Each of the first word lines WL1 may extend in the first horizontal direction (X direction) from the first stack region STR1 to the pair of first stair regions SIR1 that are disposed on both sides of the first stack region STR1 in the first horizontal direction (X direction). For example, each of the first word lines WL1 may extend from the first odd stair region SIR1_O to the first even stair region SIR1_E through the first stack region STR1. In addition, each of the second word lines WL2 may extend in the first horizontal direction (X direction) from the second stack region STR2 to the pair of second stair regions SIR2 that are disposed on both sides of the second stack region STR2 in the first horizontal direction (X direction). For example, each of the second word lines WL2 may extend from the second even stair region SIR2_E to the second odd stair region SIR2_O through the second stack region STR2.

The first and second word lines WL1 and WL2 may have a stair-like structure. The extension lengths of the first and second word lines WL1 and WL2 in the first horizontal direction (X direction) may decrease from a lower side to an upper side in the vertical direction (Z direction). For example, among the first and second word lines WL1 and WL2 arranged spaced apart from each other in the vertical direction (Z direction), the extension lengths of lower first and second word lines WL1 and WL2 measured in the first horizontal direction (X direction) may be greater than the extension lengths of upper first and second word lines WL1 and WL2 measured in the first horizontal direction (X direction).

Here, the first word lines WL1 may be respectively in 0th to nth layers, that is, respectively in (n+1) layers (where n refers to an integer greater than or equal to 1). That is, the first word lines WL1 may include a first word line WL1_0 in the 0th layer, a first word line WL1_1 in the first layer, a first word line WL1_2 in the second layer, ..., a first word line WL1_n-2 in the (n-2)th layer, a first word line WL1_n-1 in the (n-1)th layer, and a first word line WL1_n in the nth layer.

In addition, the second word lines WL2 may be respectively in 0th to nth layers, that is, respectively in (n+1) layers. That is, the second word lines WL2 may include a second word line WL2_0 in the 0th layer, a second word line WL2_1 in the first layer, a second word line WL2_2 in the second layer, ..., a second word line WL2_n-2 in the (n-2)th layer, a second word line WL2_n-1 in the (n-1)th layer, and a second word line WL2_n in the nth layer.

For ease of illustration, the 0th layer (or base layer) is described as a starting layer. However, substantially the same results may be obtained when the first layer is a starting layer. In this situation, there may be N layers, ranging from the 1^{st} layer to the N^{th} layer. In this situation, the K^{th} first word line WL1 may be connected to the (N-K+1)th second word line WL2.

Each of the first and second word lines WL1 and WL2 may include a pair of word line pads WLP at ends thereof in the first horizontal direction (X direction). First and second word line contacts WLC1 and WLC2 may be connected to every other pad of the word line pads WLP. The word line pads WLP may be connected to sub-word line drivers SWD through the first and second word line contacts WLC1 and WLC2. Lower ends of the first and second word line contacts WLC1 and WLC2 may be in contact with the word line pads WLP. In addition, upper ends of the first and second word line contacts WLC1 and WLC2 may be in contact with bonding pads BP. However, example embodiments are not limited thereto.

The stair structures SIS may extend from the first and second stack regions STR1 and STR2 to the first and second stair regions SIR1 and SIR2, and may include portions of the first and second word lines WL1 and WL2 that include the word line pads WLP.

In some example embodiments, a plurality of sub-word line drivers SWD may be electrically connected to a plurality of interconnect lines ICL that electrically connect word line pads WLP located in the first even stair region SIR1_E to word line pads WLP located in the second even stair region SIR2_E.

A plurality of sub-word line drivers SWD may be electrically connected in the same manner to a plurality of interconnect lines ICL that electrically connect word line pads WLP located in the first odd stair region SIR1_O to word line pads WLP located in the second odd stair region SIR2_O. Odd word lines may extend into odd stair regions. Even word lines may extend into even stair regions. First odd word lines from the first word lines WL1 may face (e.g. may be located on the same levels as) second odd word lines from the second word lines WL2. First even word lines from the first word lines WL1 may face (e.g. may be located on the same levels as) second even word lines from the second word lines WL2.

In the semiconductor memory device 100, a first word line WL1 in a kth layer (where k is an arbitrary integer from 0 to n) among the first word lines WL1 in the (n+1) layers, and a second word line WL2 in a (n-k)th layer among the second word lines WL2 in the (n+1) layers may be connected to a single sub-word line driver SWD. In addition, an interconnect line ICL may electrically connect a kth first word line contact WLC1, which is connected to the first word line WL1 in the kth layer, to an (n-k)th second word line contact WLC2, which is connected to the second word line WL2 in the (n-k)th layer.

Here, a (2j+1)th first word line contact WLC1 may be connected to a first word line WL1 disposed in the first odd stair region SIR1_O, and a 2jth first word line contact WLC1 may be connected to a first word line WL1 disposed in the first even stair region SIR1_E. In addition, a (2j+1)th second word line contact WLC2 may be connected to a second word line WL2 disposed in the second odd stair region SIR2_O, and a 2jth second word line contact WLC2 may be connected to a second word line WL2 disposed in the second even stair region SIR2_E. Here, j may be an integer from 0 to (n+1)/2. j may be an index for identifying adjacent pairs of odd and even wordlines. Where the numbering of the levels is changed, such that K ranges from 1 to N, J may be an integer ranging from 1 to N/2. In this instance, the first odd word lines may be connected to (2J-1)th first word line contacts WLC1 and the first even word lines may be connected to the 2Jth first word line contacts WLC1.

First word line contacts WLC1 may alternate between connecting to word line pads WLP in the first even stair region SIR1_E and the first odd stair region SIR1_O in order of ascending layers. Second word line contacts WLC2 may alternate between connecting to word line pads WLP in the second even stair region SIR2_E and the second odd stair region SIR2_O in order of ascending layers.

Here, the first word lines WL1 in the (n+1) layers extend in the first horizontal direction (X direction) and are stacked in the vertical direction (Z direction) to form the stair structures SIS. Thus, the length (or area), in the first horizontal direction (X direction), of the word line pad WLP of the first word line WL1 in the kth layer may decrease as the value of k increases. In addition, the second word lines WL2 in the (n+1) layers extend in the first horizontal direction (X direction) and are stacked in the vertical direction (Z direction) to form the stair structures SIS. Thus, the length (or area), in the first horizontal direction (X direction), of the word line pad WLP of the second word line WL2 in the (n-k)th layer may increase as the value of k increases.

In the connection method of the semiconductor memory device 100, the sub-word line drivers SWD may select desired memory cells from among the first and second memory cells MC1 and MC2 included in the first and second sub-cell arrays SCA1 and SCA2 together with the first and second bit lines BL1 and BL2 by individually activating the first word line WL1 of the kth layer connected to first memory cells MC1 and the second word line WL2 of the (n-k)th layer connected to second memory cells MC2 and corresponding to the first word line WL1 of the kth layer.

In a related three-dimensional semiconductor memory device, interconnect lines ICL are configured to connect a first word line WL1 in a kth layer and a second word line WL2 in a kth layer to each other for the wiring freedom of the interconnect lines ICL.

In this case, for example, the sum of the length (or area) of a word line pad WLP of a first word line WL1 in a first layer and the length (or area) of a word line pad WLP of a second word line WL2 in a first layer may be significantly greater than the sum of the length (or area) of a word line pad WLP of a first word line WL1 in a fifth layer and the length (or area) of a word line pad WLP of a second word line WL2 in a fifth layer.

The sum of the vertical length (Z-direction length) of a first one of first word line contacts WLC1 that makes contact with a first word line WL1 in a first layer and the vertical length of a first one of second word line contacts WLC2 that makes contact with a second word line WL2 in a first layer may be significantly greater than the sum of the vertical length of a fifth one of the first word line contacts WLC1 that makes contact with a first word line WL1 in a fifth layer and the vertical length of a fifth one of the second word line contacts WLC2 that makes contact with a second word line WL2 in a fifth layer.

Therefore, due to variations in resistance resulting from the different sums of lengths (or areas) of word line pads WLP (and different lengths of word line contacts WLC), there may be significant variations in the resistance-capacitance (RC) loading of sub-word line drivers SWD connected to the word line pads WLP. In the related art, sub-word line drivers SWD are designed to have different sizes to offset such variations in RC loading. Therefore, when the sizes of sub-word line drivers SWD are not designed as described above, errors may occur due to poor distribution of RC loading.

To address this, the semiconductor memory device 100 is configured such that a first length of a word line pad WLP of a first word line WL1 in a kth layer connected to an interconnect line ICL may be different from a second length of a word line pad WLP of a second word line WL2 in an (n-k)th layer connected to the interconnect line ICL.

In this regard, a third length, in the vertical direction (Z direction), of a kth first word line contact WLC1 connected to the interconnect line ICL may be different from a fourth length, in the vertical direction (Z direction), of an (n-k)th second word line contact WLC2 connected to the interconnect line ICL.

That is, the sum of the first length of a word line pad WLP of a first word line WL1 connected to an interconnect line ICL and the second length of a word line pad WLP of a second word line WL2 connected to the interconnect line ICL may be uniform for all interconnect lines ICL. Furthermore, the sum of the first length of a first word line contact WLC1 connected to an interconnect line ICL and the second length of a second word line contact WLC1 connected to the interconnect line ICL may be uniform for all interconnect lines ICL. In this case, even when a plurality of sub-word line drivers SWD are designed to have the same size, the RC loading of the sub-word line drives SWD may be uniform.

As described above, in the semiconductor memory device 100, the interconnect lines ICL are arranged to make uniform the RC loading of the sub-word line drivers SWD respectively connected to the first and second word lines WL1 and WL2 that are stacked in a stair structure in the vertical direction (Z direction). Thus, the sub-word line drivers SWD may have substantially the same size.

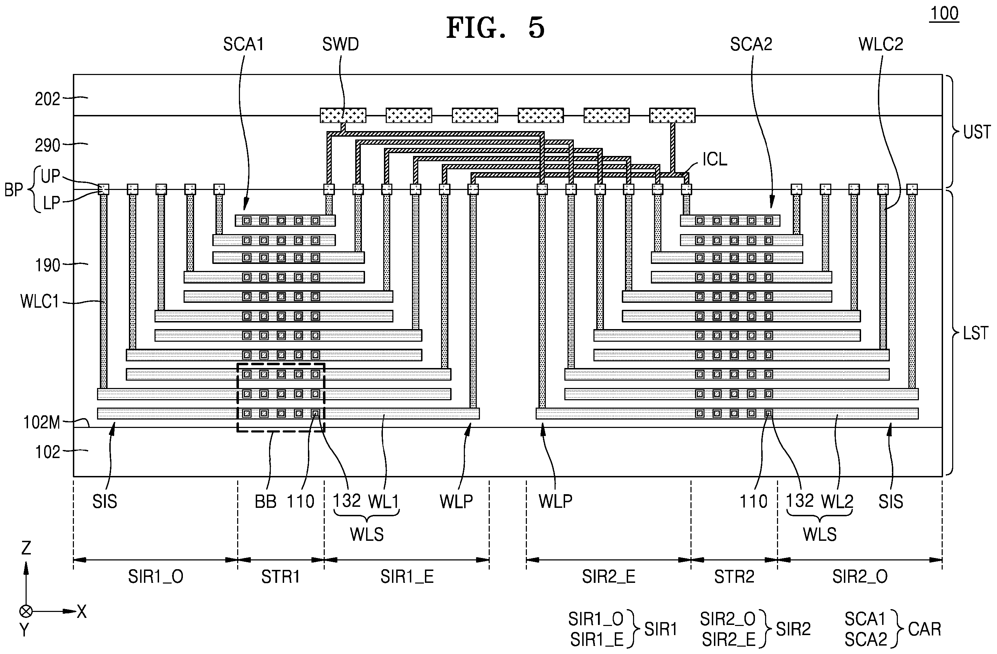

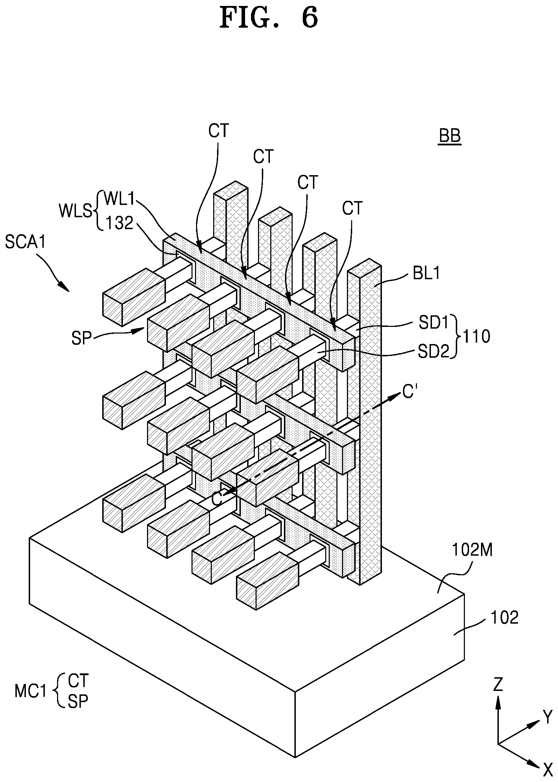

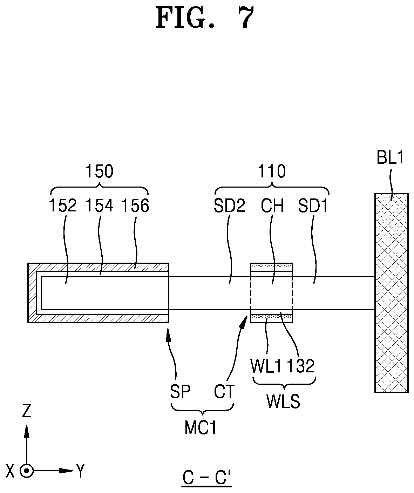

FIGS. 5 to 7 are diagrams illustrating components of a semiconductor memory device 100 according to an example embodiment. For example, FIG. 6 is an enlarged perspective diagram illustrating a region BB of FIG. 5, and FIG. 7 is an enlarged cross-sectional diagram taken along line C-C' of FIG. 6.

Referring to FIGS. 5 to 7 together, the semiconductor memory device 100 may include a lower structure LST and an upper structure UST provided on the lower structure LST.

The lower structure LST may be referred to as a first structure or a cell structure. The upper structure UST may be referred to as a second structure or a core/periphery structure.

The lower structure LST may include first and second stack regions STR1 and STR2, and first and second stair regions SIR1 and SIR2. The lower structure LST may include a cell substrate 102, first and second sub-cell arrays SCA1 and SCA2 provided in the first and second stack regions STR1 and STR2 above the cell substrate 102, and stair structures SIS provided in the first and second stair regions SIR1 and SIR2.

The first and second sub-cell arrays SCA1 and SCA2 may include a plurality of first and second word lines WL1 and WL2 arranged above a main surface 102M (e.g. the upper surface) of the cell substrate 102, a plurality of first and second bit lines BL1 and BL2 extending in a vertical direction (Z direction) from the main surface 102M of the cell substrate 102, a plurality of cell transistors CT arranged between the first and second word lines WL1 and WL2 and the first and second bit lines BL1 and BL2, and a plurality of data storage elements SP connected to the cell transistors CT. The cell transistors CT and the data storage elements SP may form first and second memory cells MC1 and MC2.

In some example embodiments, the cell substrate 102 may include silicon, for example, single-crystal silicon, polycrystalline silicon, or amorphous silicon. In other example embodiments, the cell substrate 102 may include at least one selected from the group consisting of Ge, SiGe, SiC, GaAs, InAs, and InP. In addition, the cell substrate 102 may include a conductive region such as a well region doped with a dopant or a structure doped with a dopant.

In some example embodiments, each of the first and second word lines WL1 and WL2 may be adjacent to semiconductor patterns 110. In some example embodiments, the first and second word lines WL1 and WL2 may surround the semiconductor patterns 110. Gate dielectric layers 132 may be arranged between each of the first and second word lines WL1 and WL2 and the semiconductor patterns 110. Each of the first and second word lines WL1 and WL2 and the gate dielectric layers 132 may form word line structures WLS. The semiconductor patterns 110 and the word line structures WLS may form the cell transistors CT.

The semiconductor patterns 110 may include source regions SD1, drain regions SD2, and channel regions CH arranged between the source regions SD1 and the drain regions SD2. The source regions SD1 may be connected to the first bit lines BL1, and the drain regions SD2 may be connected to the data storage elements SP. The source regions SD1, the channel regions CH, and the drain regions SD2 may be sequentially arranged in a second horizontal direction (Y direction) from the first bit lines BL1. In some example embodiments, the semiconductor patterns 110 may penetrate the first word lines WL1. For example, the channel regions CH may be portions of the semiconductor patterns 110 that penetrate the first word lines WL1. The arrangement of these components may be applied in the same manner to the second word lines WL2 and the second bit lines BL2.

The semiconductor patterns 110 may include a material having the same or similar etching characteristics as the cell substrate 102, or may include the same material as the cell substrate 102. For example, the semiconductor pattern 110 may include silicon (Si), a single-crystal semiconductor material, a two-dimensional semiconductor material, or an oxide semiconductor material.

The source regions SD1 and the drain regions SD2 of the semiconductor patterns 110 may be doped with a first dopant of a first conductivity type, and the channel regions CH may be doped with a second dopant of a second conductivity type that is different from the first conductivity type. For example, the first conductivity type may be n-type, and the second conductivity type may be p-type.

The first and second word lines WL1 and WL2 may include conductive barrier layers covering the gate dielectric layers 132, and conductive fill layers covering the conductive barrier layers. The conductive barrier layers may include, for example, a metal, a conductive metal nitride, a conductive metal silicide, or a combination thereof. In some example embodiments, the conductive fill layers may include tungsten (W).

The gate dielectric layers 132 may include at least one selected from the group consisting of silicon oxide, a high-k dielectric material (e.g. a material having a greater dielectric constant than silicon oxide), and a ferroelectric material. In some example embodiments, the gate dielectric layers 132 may each have a stack structure formed by a first dielectric layer including silicon oxide and a second dielectric layer including at least one selected from the group consisting of a high-k material and a ferroelectric material.

The first and second bit lines BL1 and BL2 may include: conductive barrier layers that are in contact with ends of the semiconductor patterns 110, for example, in contact with the source regions SD1; and conductive fill layers covering the conductive barrier layers. The conductive barrier layers may include, for example, a metal, a conductive metal nitride, a conductive metal silicide, or a combination thereof. In some example embodiments, the conductive fill layers may include tungsten (W).

The data storage elements SP may be capacitors 150. Each of the capacitors 150 may include a first electrode 152, a second electrode 156, and a capacitor dielectric layer 154 arranged between the first electrode 152 and the second electrode 156. That is, the capacitors 150 may include first electrodes 152 connected to the drain regions SD2 of the semiconductor patterns 110 and extending in the second horizontal direction (Y direction), capacitor dielectric layers 154 covering the first electrodes 152, and second electrodes 156 covering the capacitor dielectric layers 154.

The first electrodes 152 may include a metal, a conductive metal nitride, a conductive metal silicide, or a combination thereof. The capacitor dielectric layers 154 may include at least one selected from the group consisting of a high-k material and a ferroelectric material having a greater dielectric constant than silicon oxide. For example, the capacitor dielectric layers 154 may include at least one selected from the group consisting of a metal oxide or a dielectric material with a perovskite structure. The second electrodes 156 may include, for example, doped silicon or tungsten (W).

First and second word line contacts WLC1 and WLC2, connected to the first and second stair regions SIR1 and SIR2 of the first and second word lines WL1 and WL2 of the first and second sub-cell arrays SCA1 and SCA2, may have different vertical lengths in the vertical direction (Z direction). The vertical lengths of the first and second word line contacts WLC1 and WLC2 may increase away from the first and second stack regions STR1 and STR2 in the first horizontal direction (X direction). The first and second word line contacts WLC1 and WLC2 may include a metal, a conductive metal nitride, a conductive metal silicide, or a combination thereof. Lower bonding pads LP may be connected to upper ends of the first and second word line contacts WLC1 and WLC2.

A first insulating structure 190 may be provided on the cell substrate 102 to cover the first and second sub-cell arrays SCA1 and SCA1 and the stair structures SIS. The first insulating structure 190 may surround the first and second bit lines BL1 and BL2, the first and second word lines WL1 and WL2, the first and second word line contacts WLC1 and WLC2, and the lower bonding pads LP. Upper surfaces of the lower bonding pads LP and the first insulating structure 190 may be located on the same plane.

For example, the first insulating structure 190 may include an insulating material including silicon oxide, silicon nitride, a low-k material (e.g. a material having a lower dielectric constant than silicon oxide), or a combination thereof. For example, the lower bonding pads LP may include a conductive material including copper (Cu), gold (Au), silver (Ag), aluminum (Al), tungsten (W), titanium (Ti), tantalum (Ta), or a combination thereof.

The upper structure UST may include a core/periphery substrate 202, a second insulating structure 290 covering a lower side of the core/periphery substrate 202, a plurality of sub-word line drivers SWD arranged between the core/periphery substrate 202 and the second insulating structure 290, a plurality of interconnect lines ICL connected to the sub-word line drivers SWD, and a plurality of upper bonding pads UP connected to lower ends of the interconnect lines ICL.

The second insulating structure 290 may surround the interconnect lines ICL and the upper bonding pads UP. Lower surfaces of the upper bonding pads UP and a lower surface of the second insulating structure 290 may be located on the same plane.

The interconnect lines ICL may electrically connect the sub-word line drivers SWD to the upper bonding pads UP. Each of the interconnect lines ICL may include, for example, at least one wiring layer and at least one contact via.

The core/periphery substrate 202, the upper bonding pads UP, and the second insulating structure 290 may include the same materials as the cell substrate 102, the lower bonding pad LP, and the first insulating structure 190, or materials similar to those included in the cell substrate 102, the lower bonding pad LP, and the first insulating structure 190.

The second insulating structure 290 and the first insulating structure 190 may be in contact with each other, and the upper structure UST may be disposed on the lower structure LST by bonding the upper bonding pads UP and the lower bonding pads LP to each other. In some example embodiments, the lower structure LST and the upper structure UST may be bonded to each other by a metal-oxide hybrid bonding method.

With this bonding, the first and second word lines WL1 and WL2 provided in the lower structure LST may be electrically connected to the sub-word line drivers SWD provided in the upper structure UST. For example, a first word line WL1 and a second word line WL2 may be connected to a single sub-word line driver SWD through a first word line contact WLC1, a second word line contact WLC2, bonding pads BP, and an interconnect line ICL that are connected to word line pads WLP of the first and second word lines WL1 and WL2.

In the semiconductor memory device 100, the interconnect lines ICL are arranged to make uniform the RC loading of the sub-word line drivers SWD provided in the upper structure UST and connected to the first and second word lines WL1 and WL2 provided in the lower structure LST and stacked in the vertical direction (Z direction) in a stair-like structure. Thus, the sub-word line drivers SWD provided in the upper structure UST may be substantially the same size.

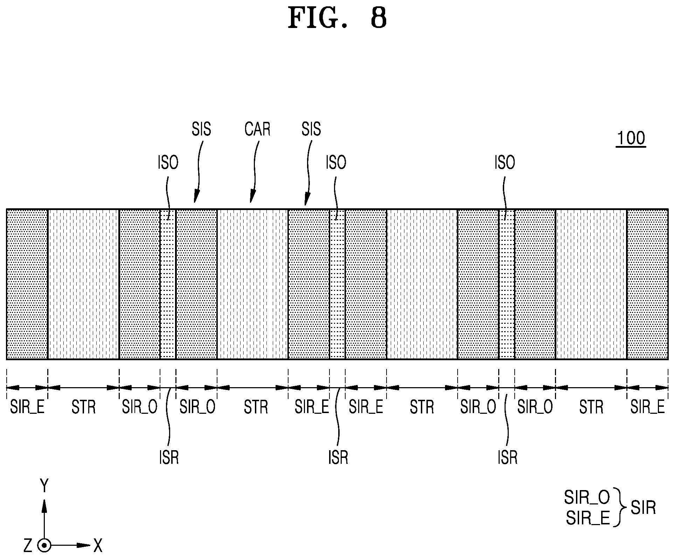

FIG. 8 is a plan layout schematically illustrating a semiconductor memory device 100 according to an example embodiment.

Referring to FIG. 8, the semiconductor memory device 100 may include a plurality of stack regions STR, a plurality of stair regions SIR, and a plurality of isolation insulating regions ISR.

Cell array structures CAR may be provided in the stack regions STR. The stack regions STR are spaced apart from each other in a first horizontal direction (X direction). A pair of stair regions SIR may be arranged at ends of each of the stack regions STR in the first horizontal direction (X direction).

The pair of stair regions SIR arranged at ends of each of the stack regions STR in the first horizontal direction (X direction) may include an odd stair region SIR_O on a side of the stack region STR and an even stair region SIR_E on the other side of the stack region STR. Stair structures SIS may be provided in the stair regions SIR.

A plurality of isolation insulating structures ISO may be provided in the isolation insulating regions ISR. Each of the isolation insulating regions ISR may be disposed between a pair of stair regions SIR, that is, between odd stair regions SIR_O or even stair regions SIR_E, which are disposed between a pair of adjacent stack regions STR in the first horizontal direction (X direction).

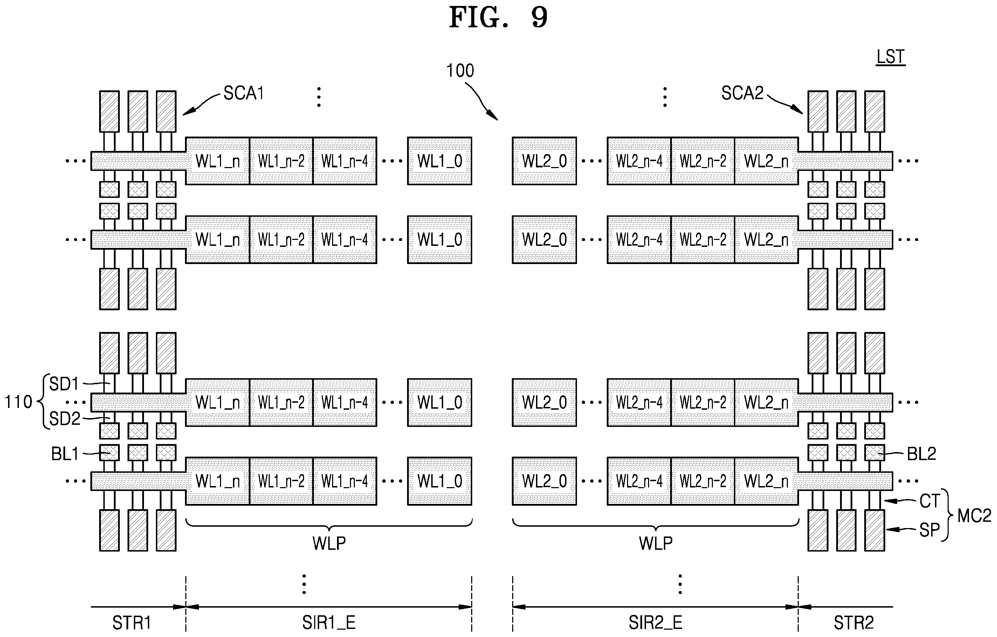

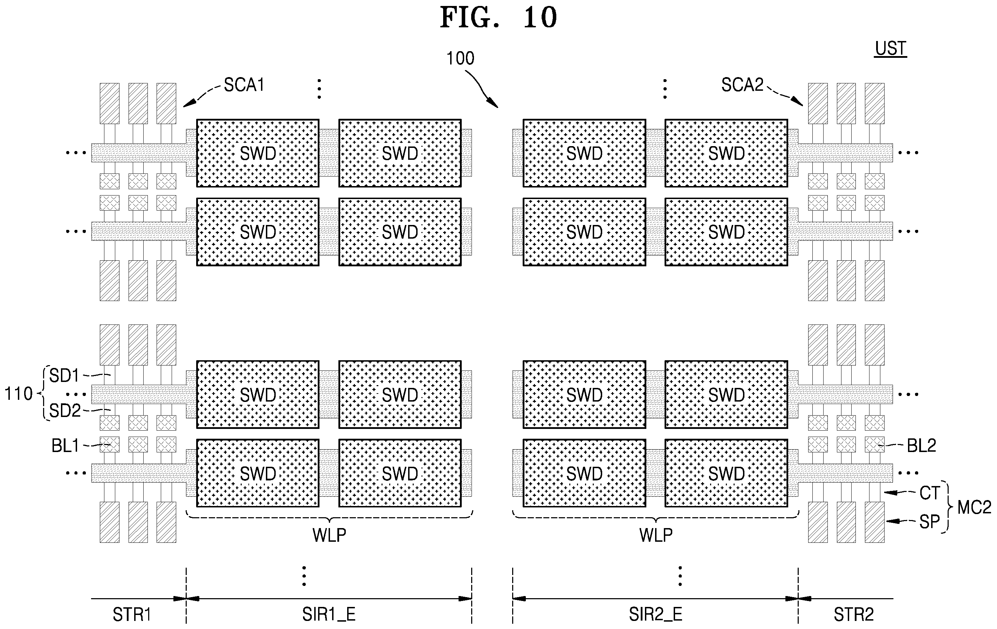

FIGS. 9 and 10 are plan diagrams respectively illustrating a lower structure and an upper structure of a semiconductor memory device 100 according to an example embodiment.

Referring to FIGS. 9 and 10 together, the semiconductor memory device 100 may include a first stack region STR1, a second stack region STR2, and stair regions SIR.

In the lower structure LST, cell array structures CAR may be provided in the first and second stack regions STR1 and STR2, and stair structures SIS may be provided in the stair regions SIR. The cell array structures CAR may include a first sub-cell array SCA1 and a second sub-cell array SCA2.

In the lower structure LST, the stair regions SIR may be arranged on both sides of each of the first and second stack regions STR1 and STR2 in a first horizontal direction (X direction). A pair of stair regions SIR may be disposed at both sides of the first stack region STR1 in the first horizontal direction (X direction), and a pair of stair regions SIR may be disposed at both sides of the second stack region STR2 in the first horizontal direction (X direction). The pairs of stair regions SIR may include: first and second odd stair regions disposed on sides of the first and second stack regions STR1 and STR2 in the first horizontal direction (X direction); and first and second even stair regions SIR1_E and SIR2_E disposed on the other sides of the first and second stack regions STR1 and STR2. The stair structures SIS may be provided in the stair regions SIR.

In the lower structure LST, the first and second sub-cell arrays SCA1 and SCA2 may include a plurality of first and second word lines WL1 and WL2, a plurality of first and second bit lines BL1 and BL2, and a plurality of first and second memory cells MC1 and MC2 arranged between the first and second word lines WL1 and WL2 and the first and second bit lines BL1 and BL2 and each including a cell transistor CT and a data storage element SP.

In the lower structure LST, the first and second word lines WL1 and WL2 may extend in the first horizontal direction (X direction) and may be spaced apart from each other in a vertical direction (Z direction).

In the lower structure LST, among the first word lines WL1, a first word line WL1 in a 0th layer, ..., a first word line WL1_n-4 in an (n-4)th layer, a first word line WL1_n-2 in an (n-2)th layer, and a first word line WL1_n in an nth layer may be spaced apart from each other in the first even stair region SIR1_E from a lower side to an upper side in the vertical direction (Z direction).

In the lower structure LST, among the second word lines WL2, a second word line WL2 in a 0th layer, ..., a second word line WL2_n-4 in an (n-4)th layer, a second word line WL2_n-2 in an (n-2)th layer, and a second word line WL2_n in an nth layer may be spaced apart from each other in the second even stair region SIR2_E from a lower side to an upper side in the vertical direction (Z direction).

In the upper structure UST, a plurality of sub-word line drivers SWD may be electrically connected to a plurality of interconnect lines that electrically connect word line pads WLP located in the first even stair region SIR1_E to word line pads WLP located in the second even stair region SIR2_E.

In the semiconductor memory device 100, a first word line WL1 in a kth layer and a second word line WL2 in an (n-k)th layer that are arranged in the lower structure LST may be connected to a single sub-word line driver SWD provided in the upper structure UST.

Here, as the value of k increases, the length (or area), in the first horizontal direction (X direction), of a word line pad WLP of the first word line WL1 in the kth layer may decrease, and the length (or area), in the first horizontal direction (X direction), of a word line pad WLP of the second word line WL2 in the (n-k)th layer may increase. Similarly, as the value of k increases, the length of a first word line contact WLC1 connected to a first word line WL1 in the kth layer may decrease, and the length of a second word line contact WLC2 connected to a second word line WL2 in the (n-k)th layer may increase.

According to the method of connecting the lower structure LST and the upper structure UST to each other in the connection method of the semiconductor memory device 100, the sub-word line drivers SWD may select desired memory cells from among the first and second memory cells MC1 and MC2 included in the first and second sub-cell arrays SCA1 and SCA2 together with the first and second bit lines BL1 and BL2 by individually activating the first word line WL1 of the kth layer connected to first memory cells MC1 and the second word line WL2 of the (n-k)th layer connected to second memory cells MC2 and corresponding to the first word line WL1 of the kth layer.

In the semiconductor memory device 100, the interconnect lines are arranged to make uniform the RC loading of the sub-word line drivers SWD provided in the upper structure UST and connected to the first and second word lines WL1 and WL2 provided in the lower structure LST and stacked in the vertical direction (Z direction) in a stair-like structure. Thus, the sub-word line drivers SWD provided in the upper structure UST may be substantially the same size.

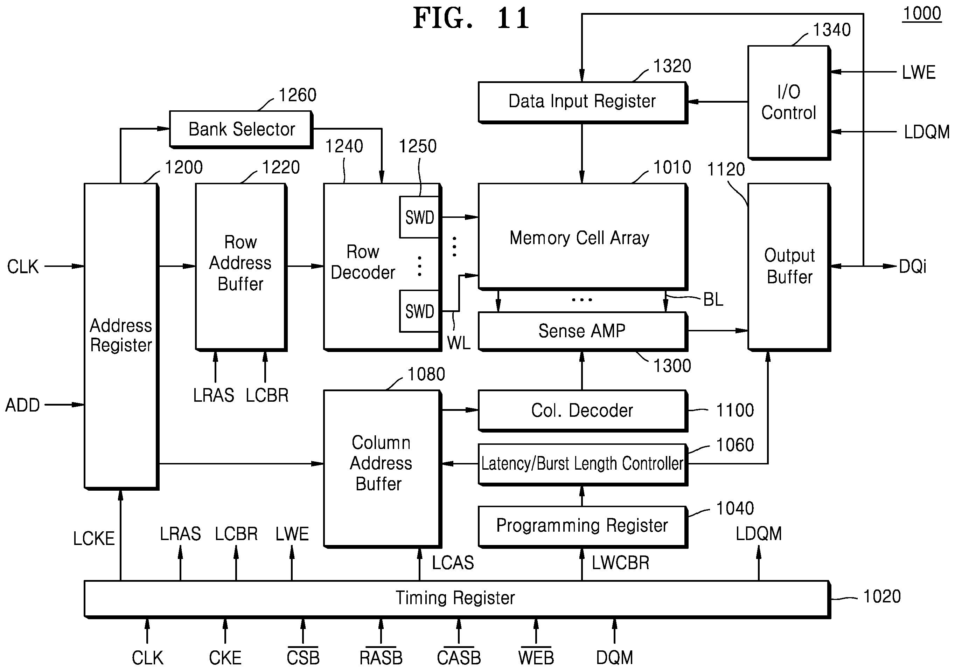

FIG. 11 is a block diagram illustrating a semiconductor memory device 1000 according to an example embodiment.

Referring to FIG. 11, the semiconductor memory device 1000 may include a memory cell array 1010 including DRAM cells as memory cells, and various circuit blocks for driving the DRAM cells.

In some example embodiments, a timing register 1020 may be activated when a chip select signal CSB changes from an inactive level (for example, logic high) to an active level (for example, logic low). The timing register 1020 may receive command signals such as a clock signal CLK, a clock enable signal CKE, a chip select signal CSB, a row address strobe signal RASB, a column address strobe signal CASB, a write enable signal WEB, and a data input/output mask signal DQM from the outside, process the received command signals, and generate various internal command signals LCKE, LRAS, LCBR, LWE, LCAS, LWCBR, and LDQM to control the circuit blocks.

Some internal command signals generated by the timing register 1020 are stored in a programming register 1040. For example, latency information or burst length information related to data output may be stored in the programming register 1040.

The internal command signals stored in the programming register 1040 may be provided to a latency/burst length controller 1060, and the latency/burst length controller 1060 may provide control signals to a column decoder 1100 through a column address buffer 1080 or to an output buffer 1120 to control the latency or burst length of data output.

An address register 1200 may receive a clock signal CLK and an address signal ADD from the outside. A row address signal may be provided to a row decoder 1240 through a row address buffer 1220. In addition, a column address signal may be provided to the column decoder 1100 through the column address buffer 1080.

The row address buffer 1220 may further receive a refresh address signal that is generated by a refresh counter in response to refresh commands LRAS and LCBR and may provide either the row address signal or the refresh address signal to the row decoder 1240. In addition, the address register 1200 may provide a bank signal for selecting a bank to a bank selector 1260.

The row decoder 1240 may decode the row address signal or the refresh address signal input from the row address buffer 1220. The row decoder 1240 may include a plurality of sub-word line drivers 1250. The sub-word line drivers 1250 may activate word lines WL of the memory cell array 1010. The sub-word line drivers 1250 may form blocks that are adjacent to the memory cell array 1010 and arranged at predetermined intervals within the row decoder 1240. For example, the sub-word line drivers 1250 may be arranged adjacent to an end of the memory cell array 1010 in a direction perpendicular to a sense amplifier 1300.

Here, the sub-word line drivers 1250 may correspond to the sub-word line drivers SWD of the semiconductor memory device 100 of example embodiments described above.

The column decoder 1100 may decode the column address signal and may perform a selection operation to select bit lines BL of the memory cell array 1010. In some example embodiments, a column selection line may be applied to the semiconductor memory device 1000, and the selection operation may be performed through the column selection line.

The sense amplifier 1300 may amplify data of a memory cell selected by the row decoder 1240 and the column decoder 1100 and provide the amplified data to the output buffer 1120. Data to be stored in memory cells may be provided to the memory cell array 1010 through a data input register 1320, and an input/output (I/O) controller 1340 may control data transfer occurring through the data input register 1320.

Embodiments are set out in the following Clauses:
Clause 1. A semiconductor memory device comprising:
   a substrate comprising a first stack region, first stair regions provided at ends of the first stack region, a second stack region, and second stair regions provided at ends of the second stack region;
   first word lines in N layers (where N refers to an integer greater than or equal to 2), the first word lines extending from the first stack region toward the first stair regions and being spaced apart from each other in a vertical direction;
   second word lines in the N layers, the second word lines extending from the second stack region toward the second stair regions and being spaced apart from each other in the vertical direction;
   first bit lines in the first stack region extending in the vertical direction;
   second bit lines in the second stack region extending in the vertical direction;
   first memory cells provided in the first stack region and between the first word lines and the first bit lines;
   second memory cells provided in the second stack region and between the second word lines and the second bit lines;
   N first word line contacts connected to pads of the first word lines in the first stair regions; and
   N second word line contacts connected to pads of the second word lines in the second stair regions,
   wherein a first word line in a Kth layer (wherein, K refers to an integer from 1 to N) among the first word lines in the N layers and a second word line in an (N-K+1)th layer among the second word lines in the N layers are commonly connected to one sub-word line driver.
Clause 2. The semiconductor memory device of Clause 1, wherein each of the first word lines in the N layers and each of the second word lines in the N layers extends in a first horizontal direction, and
   wherein as K increases, a length, in the first horizontal direction, of the pads of the first word lines decreases, and a length, in the first horizontal direction, of the pads of the second word lines connected to the first word lines increases.
Clause 3. The semiconductor memory device of Clause 1 or Clause 2, wherein a Kth first word line contact connected to the first word line in the Kth layer and a (N-K+1)th second word line contact connected to the second word line in the (N-K+1)th layer are electrically connected to each other.
Clause 4. The semiconductor memory device of Clause 3, wherein a first length, in the vertical direction, of the Kth first word line contact is different from a second length, in the vertical direction, of the (N-K+1)th second word line contact.
Clause 5. The semiconductor memory device of any preceding Clause, wherein the first word lines in the N layers comprise first odd word lines and first even word lines,
   wherein the second word lines in the N layers comprise second odd word lines and second even word lines,
   wherein the first odd word lines face the second odd word lines, and
   wherein the first even word lines face the second even word lines.
Clause 6. The semiconductor memory device of Clause 5, wherein the first odd word lines and the second odd word lines are electrically connected to each other such that a first odd word line and a second odd word line are electrically connected to each other through a (2K-1)th first word line contact and a second word line contact corresponding to the (2K-1)th first word line contact, and
   wherein the first even word lines and the second even word lines are electrically connected to each other such that a first even word line and a second even word line are electrically connected to each other through a 2Kth first word line contact and a second word line contact corresponding to the 2Kth first word line contact.
Clause 7. The semiconductor memory device of any preceding Clause, further comprising cell transistors and data storage elements respectively corresponding to the first memory cells and the second memory cells,
   wherein the cell transistors of the first memory cells comprise semiconductor patterns extending from the first bit lines in a second horizontal direction crossing the first horizontal direction, and
   wherein the cell transistors of the second memory cells comprise semiconductor patterns extending from the second bit lines in the second horizontal direction.
Clause 8. The semiconductor memory device of Clause 7, wherein the semiconductor patterns comprise source regions, channel regions, and drain regions,
   wherein the source regions are connected to the first and second bit lines, and
   wherein the drain regions are connected to the data storage elements, and wherein the channel regions are provided between the drain regions and the first and second bit lines.
Clause 9. The semiconductor memory device of Clause 8, wherein the semiconductor patterns penetrate the first and second word lines, and
   wherein the channel regions are portions of the semiconductor patterns penetrating the first and second word lines.
Clause 10. The semiconductor memory device of Clause 8 or Clause 9, wherein the data storage elements comprise capacitors, the capacitors comprising:
   first electrodes connected to the drain regions;
   capacitor dielectric layers covering the first electrodes; and
   second electrodes covering the capacitor dielectric layers.
Clause 11. A semiconductor memory device comprising:
   a lower structure; and
   an upper structure on the lower structure,
   wherein the lower structure comprises:
      a cell substrate comprising a first stack region, first stair regions provided at ends of the first stack region, a second stack region, and second stair regions provided at ends of the second stack region;
      first word lines in N layers (where N refers to an integer greater than or equal to 2), the first word lines extending from the first stack region toward the first stair regions and being spaced apart from each other in a vertical direction;
      second word lines in the N layers, the second word lines extending from the second stack region toward the second stair regions and being spaced apart from each other in the vertical direction;
      first bit lines in the first stack region extending in the vertical direction;
      second bit lines in the second stack region extending in the vertical direction;
      first memory cells provided in the first stack region between the first word lines and the first bit lines;
      second memory cells provided in the second stack region between the second word lines and the second bit lines;
      N first word line contacts connected to the first word lines of the N layers in the first stair regions; and
      N second word line contacts connected to the second word lines of the N layers in the second stair regions,
   wherein the upper structure comprises:
      a core/periphery substrate;
      a plurality of sub-word line drivers; and
      a plurality of interconnect lines connecting the plurality of sub-word line drivers to the N first word line contacts and the N second word line contacts, and
   wherein a first word line in a Kth layer (wherein, K refers to an integer from 1 to N) among the first word lines in the N layers and a second word line in an (N-K+1)th layer among the second word lines in the N layers are commonly connected to one of the plurality of sub-word line drivers in the upper structure.
Clause 12. The semiconductor memory device of Clause 11, wherein a Kth first word line contact connected to the first word line in the Kth layer and a (N-K+1)th second word line contact connected to the second word line in the (N-K+1)th layer are electrically connected to each other.
Clause 13. The semiconductor memory device of Clause 12, wherein a first length, in the vertical direction, of the Kth first word line contact is different from a second length, in the vertical direction, of the (N-K+1)th second word line contact.
Clause 14. The semiconductor memory device of Clause 13, wherein the lower structure further comprises a first insulating structure provided on the cell substrate and covering the first word lines, the second word lines, the first bit lines, the second bit lines, the first memory cells, the second memory cells, the N first word line contacts, and the N second word line contacts, and
wherein the upper structure further comprises a second insulating structure provided between the core/periphery substrate and the lower structure, covering the plurality of interconnect lines, and contacting the first insulating structure.
Clause 15. The semiconductor memory device of Clause 14, further comprising bonding pads connecting the N first word line contacts and the N second word line contacts to the plurality of interconnect lines,
   wherein lower portions of the bonding pads are surrounded by the first insulating structure, and upper portions of the bonding pads are surrounded by the second insulating structure.

While aspects of example embodiments have been particularly shown and described, it will be understood that various changes in form and details may be made therein without departing from the scope of the following claims.

## Claims

1. A semiconductor memory device comprising:
a substrate comprising a first stack region (STR1), first stair regions (SIR1_E, SIR1_O) provided at ends of the first stack region (STR1), a second stack region (STR2), and second stair regions (SIR2_E, SIR2_O) provided at ends of the second stack region (STR2);
first word lines (WL1) in N layers, where N refers to an integer greater than or equal to 2, the first word lines (WL1) extending from the first stack region (STR1) toward the first stair regions (SIR1_E, SIR1_O) and being spaced apart from each other in a vertical direction;
second word lines (WL2) in the N layers, the second word lines (WL2) extending from the second stack region (STR2) toward the second stair regions (SIR2_E, SIR2_O) and being spaced apart from each other in the vertical direction;
first bit lines (BL1) in the first stack region (STR1) extending in the vertical direction;
second bit lines (BL2) in the second stack region (STR2) extending in the vertical direction;
first memory cells (MC1) provided in the first stack region (STR1) and between the first word lines (WL1) and the first bit lines (BL1);
second memory cells (MC2) provided in the second stack region (STR2) and between the second word lines (WL2) and the second bit lines (BL2);
N first word line contacts (WLC1) connected to pads of the first word lines (WL1) in the first stair regions (SIR1_E, SIR1_O); and
N second word line contacts (WLC2) connected to pads of the second word lines (WL2) in the second stair regions (SIR2_E, SIR2_O),
wherein a first word line (WL1) in a Kth layer, wherein, K refers to an integer from 1 to N, among the first word lines (WL1) in the N layers and a second word line (WL2) in an (N-K+1)th layer among the second word lines (WL2) in the N layers are commonly connected to one sub-word line driver (SWD).

2. The semiconductor memory device of claim 1, wherein each of the first word lines (WL1) in the N layers and each of the second word lines (WL2) in the N layers extends in a first horizontal direction, and
wherein as K increases, a length, in the first horizontal direction, of the pads of the first word lines (WL1) decreases, and a length, in the first horizontal direction, of the pads of the second word lines (WL2) connected to the first word lines (WL1) increases.

3. The semiconductor memory device of claim 1 or claim 2, wherein a Kth first word line contact (WLC1) connected to the first word line (WL1) in the Kth layer and a (N-K+1)th second word line contact (WLC2) connected to the second word line (WL2) in the (N-K+1)th layer are electrically connected to each other.

4. The semiconductor memory device of claim 3, wherein a first length, in the vertical direction, of the Kth first word line contact (WLC2) is different from a second length, in the vertical direction, of the (N-K+1)th second word line contact (WLC2).

5. The semiconductor memory device of any preceding claim, wherein the first word lines (WL1) in the N layers comprise first odd word lines and first even word lines,
wherein the second word lines (WL2) in the N layers comprise second odd word lines and second even word lines,
wherein the first odd word lines face the second odd word lines, and
wherein the first even word lines face the second even word lines.

6. The semiconductor memory device of claim 5, wherein the first odd word lines and the second odd word lines are electrically connected to each other such that a first odd word line and a second odd word line are electrically connected to each other through a (2J-1)th first word line contact (WLC1) and a second word line contact (WLC2) corresponding to the (2J-1)th first word line contact, where J refers to an integer from 1 to N/2, and
wherein the first even word lines and the second even word lines are electrically connected to each other such that a first even word line and a second even word line are electrically connected to each other through a 2Jth first word line contact (WLC1) and a second word line contact (WLC2) corresponding to the 2Jth first word line contact.

7. The semiconductor memory device of any preceding claim, further comprising cell transistors (CT) and data storage elements (SP) respectively corresponding to the first memory cells (MC1) and the second memory cells (MC2),
wherein the cell transistors (CT) of the first memory cells (MC1) comprise semiconductor patterns (110) extending from the first bit lines (BL1) in a second horizontal direction crossing the first horizontal direction, and
wherein the cell transistors (CT) of the second memory cells (MC2) comprise semiconductor patterns (110) extending from the second bit lines (BL2) in the second horizontal direction.

8. The semiconductor memory device of claim 7, wherein the semiconductor patterns comprise (110) source regions (SD1), channel regions (CH), and drain regions (SD2),
wherein the source regions (SD1) are connected to the first and second bit lines (BL1, BL2),
wherein the drain regions (SD2) are connected to the data storage elements (SP), and wherein the channel regions (CH) are provided between the drain regions (SD2) and the first and second bit lines (BL1, BL2).

9. The semiconductor memory device of claim 8, wherein the semiconductor patterns (110) penetrate the first and second word lines (WL1, WL2), and
wherein the channel regions (CH) are portions of the semiconductor patterns (110) penetrating the first and second word lines (WL1, WL2).

10. The semiconductor memory device of claim 8 or claim 9, wherein the data storage elements (SP) comprise capacitors (150), the capacitors (150) comprising:
first electrodes (152) connected to the drain regions (SD2);
capacitor dielectric layers (154) covering the first electrodes (152); and
second electrodes (156) covering the capacitor dielectric layers (154).

11. A semiconductor memory device according to any preceding claim, the semiconductor memory device comprising:
a lower structure (LST); and
an upper structure (UST) on the lower structure (LST),
wherein the lower structure (LST) comprises the first word lines (WL1), the second word lines (WL2), the first bit lines (BL1), the second bit lines (BL2), the first memory cells (MC1), the second memory cells (MC2), the N first word line contacts (WLC1), the N second word line contacts (WLC2), and a cell substrate (102) comprising the first stack region (STR1), the first stair regions (SIR1_E, SIR1_O), the second stack region (STR2), and the second stair regions (SIR2_E, SIR2_O),
wherein the upper structure (UST) comprises:
a core/periphery substrate (202);
a plurality of sub-word line drivers (SWD) comprising the one sub-word line driver (SWD); and
a plurality of interconnect lines (ICL) connecting the plurality of sub-word line drivers (SWD) to the N first word line contacts (WLC1) and the N second word line contacts (WLC2).

12. The semiconductor memory device of claim 11, wherein the lower structure (LST) further comprises a first insulating structure (190) provided on the cell substrate (102) and covering the first word lines (WL1), the second word lines (WL2), the first bit lines (BL1), the second bit lines (BL2), the first memory cells (MC1), the second memory cells (MC2), the N first word line contacts (WLC1), and the N second word line contacts (WLC2), and
wherein the upper structure (UST) further comprises a second insulating structure (290) provided between the core/periphery substrate (202) and the lower structure (LST), covering the plurality of interconnect lines (ICT), and contacting the first insulating structure (190).

13. The semiconductor memory device of claim 12, further comprising bonding pads (BP) connecting the N first word line contacts (WLC1) and the N second word line contacts (WLC2) to the plurality of interconnect lines (ICL),
wherein lower portions (LP) of the bonding pads (BP) are surrounded by the first insulating structure (190), and upper portions (UP) of the bonding pads (BP) are surrounded by the second insulating structure (290).
